# EUROPEAN PATENT APPLICATION

(11) **EP 0 887 597 A2**
(43) Date of publication of application: **30.12.1998**
(21) Application number: 98111365.7
(22) Date of filing: 19.06.1998
(51) Int. Cl.: F24F 7/00, A45B 3/00, A01M 1/04, H01L 31/04

(54) **Support for independently-powered interchangeable sun shielding-ventilation-gas heating devices**

(30) Priority: 25.06.1997 IT MI971502
(71) Applicant: B.I. S.r.l., 20131 Milano (IT)
(72) Inventor: Zamarin, Giorgio Augusto, 20131 Milano (IT)
(74) Representative: Modiano, Guido, Dr.-Ing.

(57) **Abstract**

A support for independently-powered ventilation devices alternatively interchangeable with conventional gas-fired heating heads or the like, used in sunshades of bathing establishments or on supports for heating heads of the gas-fired type or the like comprising a tubular post (1) which is stably anchored to a footing (7a) shaped like an openable box-like body and is contoured, in an upward region, so that it has one or more arms (2,2a-2c) which are directed substantially horizontally, with, at the free end of the one or more arms, a canopy of a sunshade or the like being detachably fixable, along with a corresponding conventional ventilation device and, alternatively, a conventional heating head of the gas-fired, electric-resistor or solar-panel type, wherein the substantially horizontal arms (2,2a-2c) are associated with the tubular post (1) so that they are angularly spaced in a radial arrangement and, if required, are also able to rotate with respect to each other, a rechargeable battery or a solar panel being also provided for independently powering the fans, which is enclosed in the footing (7a) and is connected to the mains power grid, and a gas bottle for supplying gas to the heating heads, which can be alternately accommodated in the footing instead of the battery.

## Description

The present invention relates to a multipurpose support for independently-powered ventilation devices interchangeable with gas-fired heating devices, particularly adapted for shielding outdoor spaces, such as bathing establishments, from the sun and for heating indoor and outdoor spaces in general.

It is well-known that various kinds of devices for protection against direct solar radiation are generally used in super bathing establishments; said devices are often folding sunshades and/or horizontal awnings which are fixed or can be rolled up on fixed posts; in other cases, especially in areas looking onto seaside beaches, said sunshades and awnings are used to provide comfortable environments for customers of open-air restaurants or for recreation even during the periods of the day when the sun is strongest.

It is also well-known that various solutions have already been proposed to improve the comfort of people staying under conventional awnings, sunshades and the like; among them, the most important and effective is to provide, at the top of the post that supports the fixed or folding sunshade, a fan which is powered independently by means of rechargeable batteries or by direct connection to the municipal electric power grid or also by means of power generated by a solar panel located on the outside of the top of the sunshade.

It is also known that a liquefied-gas heating apparatus is currently used to heat open-air spaces (terraces, gardens and the like), in certain periods of the year; such an apparatus is capable of diffusing heat by radiation over an area which is not very large but it is in any case sufficient to maintain a constant temperature, for example to allow the open-air operation of restaurants or to allow gatherings of people in a garden or on private terraces even in autumn and spring.

Said heating apparatuses are generally constituted by a box-like supporting body which has an openable door and inside which there is a conventional LPG bottle, or by an electric resistor, by a tubular post which rises vertically from the supporting body and supports, at its upper free end, a heating head which is constituted by a generally cage-like body which contains a gas-fired burner which is capable of emitting heat by radiation; inside the post there is a pipe, made of copper or the like, which is meant to connect the burner to the expansion valve associated with the bottle. Said head is furthermore protected peripherally by a metallic mesh and has an upper dome meant to direct the heat downwards. Said head is furthermore applied to the top of the post so that it can be easily separated from said post.

In practice, these conventional devices for protecting from solar radiation and for heating when necessary, through being interchangeable, are always installed at the top of a straight post which, in the case of sunshades or awnings, but also in the case of operation as heaters, always has an undesirably bulk in the very region where deck-chairs or sun-beds should be placed in order to allow the required refreshment (or heating) of customers.

Furthermore, conventional ventilation and heating devices are to be used on the same single post and in a fixed position; accordingly, if it is necessary to ventilate (or heat) large areas exposed to the sun it is necessary to place a plurality of posts, and the corresponding sunshades (or heating heads) within the area to be protected, and this clearly causes greater bulk due to the several posts and to the corresponding footings.

The aim of the present invention is to provide a support for sunshades and heating heads which is conceived so as to obviate the drawbacks, mostly in terms of bulk, of current supporting means, with evident advantages as regards uncluttered access to the area that is protected against solar radiation (or is heated).

An object of the invention is to provide a multipurpose support, i.e., a support which is adapted to support one or more sunshades, each of which has a ventilation device or, as an alternative, a heating head, with evident practical and economic advantages.

Another object is to provide a support which allows, if required, to vary the orientation of the sunshades or of the heating heads.

This aim, these objects and others which may become apparent hereinafter are achieved by a multipurpose support for independently-powered ventilation devices alternatively interchangeable with gas-fired heating devices, used in sunshades, awnings and the like for bathing establishments or on supports of radiating heads for heating outdoor and indoor spaces, wherein said ventilation devices comprise independently-powered fans and said heating devices are constituted by heating heads fired by gas which is fed from bottles enclosed in a box-like body associated with the post that supports said sunshades and said radiating heads, said support being constituted, according to the present invention, by a tubular post which is stably anchored to a footing which is shaped like an openable box-like body and is contoured, in an upward region, so that it has one or more arms which are directed substantially horizontally, means being provided, at the free end of said one or more arms, for the detachable coupling of the canopy of a sunshade or the like with the corresponding conventional ventilation device and, alternatively, for the direct coupling of a conventional heating head of the gas-fired, electric-resistor or solar-panel type, said substantially horizontal arms being associated with said tubular post so that they are angularly spaced in a radial arrangement and, if required, being also able to rotate with respect to each other; means being also provided for independently powering the motor of said fans, said means being constituted by a rechargeable battery, which is enclosed in said box-like footing and is connected to the mains power grid, or by a solar panel; and means for supplying gas to said heating head, which are constituted by a bottle which can be alternately accommodated in said footing instead of said battery.

More particularly, said tubular post is provided, according to a first embodiment, by a single tubular body which is curved in its upper region so as to have a substantially horizontal arm whose length allows to support, in a cantilevered manner with respect to the straight post, the canopy of a conventional circular, quadrangular or polygonal sunshade of the fixed or folding type and the corresponding ventilation or heating devices.

According to another embodiment, said tubular post is constituted by a vertical portion at the top of which a plurality of horizontally-arranged straight or curved arms are stably or rotatably anchored; each arm supports a sunshade with a ventilation device or a heating device and said arms have a length which allows the canopies of the sunshades to protect from solar radiation a large underlying area with the bulk of a single central post.

Furthermore, at least the vertical portion of said tubular post is provided so that it can be telescopically inserted, and thus easily detached, within a portion of tube which protrudes from, or is included in, the box-like supporting body; likewise, a single fan or a single heating head may be associated with the end of each arm.

Further characteristics and advantages of the present invention will become apparent from the following detailed description, given with reference to the accompanying drawings, which are provided only by way of non-limitative example and wherein:
Figure 1 is a schematic view of a support according to the present invention, with a single lateral arm for a sunshade equipped with a fan, which can be alternatively coupled to a conventional heating head;
Figure 2 is a schematic view of a structure according to the present invention, with three arched arms for supporting three sunshades and the related devices;
Figure 3 is a view of another embodiment of the support according to the present invention, with four straight horizontal arms and with corresponding sunshades;
Figure 4 is a schematic sectional view of a support having a single arched arm which supports a conventional heating head, according to the present invention;
Figure 4a is a view illustrating only the heating head used in the support of Figure 4;
Figures 5, 6 and 7 are views of three other embodiments of the support according to the present invention;
Figures 8a, 8b, 8c, 9 and 10a, 10b are views of other embodiments with a linear burner and/or with fans having optionally folding blades; and
Figures 11, 11a, 12, 13 and 14 are views of travel umbrellas with a fan or with a solar heating panel.

With reference to the above figures, the multipurpose support according to the present invention is substantially based on the use of a single tubular post which is shaped, in its upward region, so as to form one or more arched or straight arms which are arranged in a substantially horizontal position and have in any case such dimensions as to retain, in a cantilevered manner, a conventional sunshade with a fan or a conventional heating head, in a position which is spaced enough from the post to allow to utilize all of the free area protected by the sunshade.

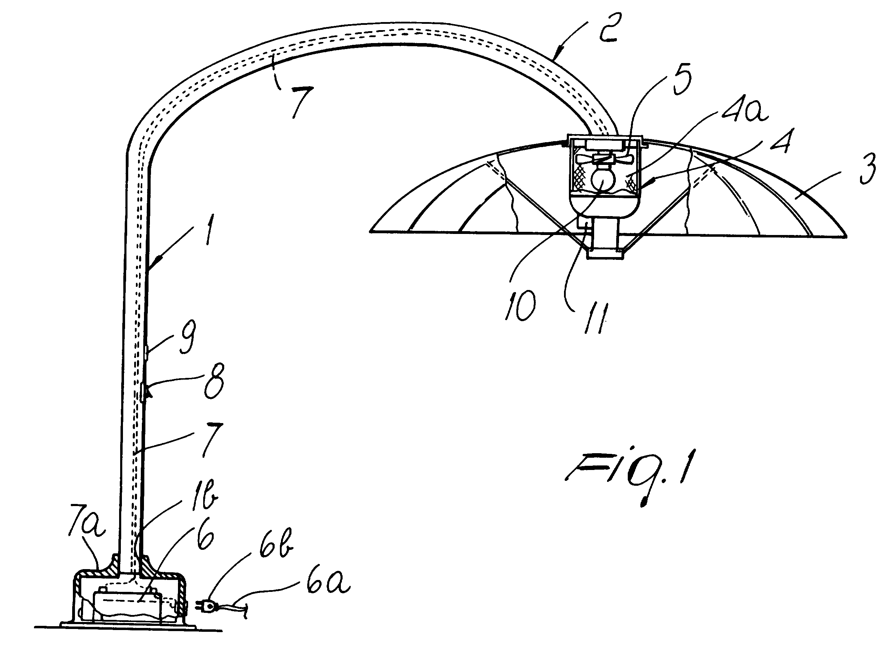

Figure 1 illustrates a support for a sunshade and a corresponding fan, wherein the load-bearing part is constituted by a tubular post 1 which, at a certain elevation above the ground, is curved so as to have an arched arm 2; said arm 2 has such a length as to support a conventional sunshade 3 at its free end.

A conventional ventilation device 4, with a body shaped like a cage which is closed peripherally by a protective mesh 4a, is stably anchored inside the sunshade to the free end of said curved arm 2; a fan of the multispeed DC type is located on the upper inside wall of the cage-like body 4a and is electrically connected to a rechargeable battery by means of a cable 7 arranged inside the post; said fan 5 can also be connected to a solar panel (conventional semiconductor photocells) which is anchored above the cage-like body 4a and is not shown in the figure.

Said canopy 3 with inclined sides, shaped like the canopy of a conventional sunshade for protection against solar radiation, is stably anchored to the peripheral region of the cage-like body 4a.

In this case, the sunshade is of the fixed type, i.e., it cannot be folded; however, it can also be provided so that it can fold.

The ventilation device 5 is also provided with a combined speed selector-power switch 8 to allow to reach the chosen fan speeds, and with at least one power outlet 9, connected to the internal cable 7, for the connection of household appliances such as a portable telephone, radio, television set and the like. It is also possible to provide a luminaire 10 associated with the central body of the fan 5 and, in some cases, an infrared- or ultraviolet-radiation device 11 for attracting and destroying various insects, such as mosquitoes, flies and the like.

The device of Figure 1 described above allows the fan to rotate by means of the direct power supply provided by the solar panel or, when solar radiation is not sufficient to generate the electric power absorbed by the fan, by means of the power supplied by the battery 6, which can be recharged by means of the cable 6a and the corresponding plug 6b.

The advantage in terms of comfort offered by the fan to users, especially during peak solar radiation hours, is evident from the above description.

Furthermore, the particular arched configuration of the tubular post 1-2 allows the sunshade to protect an area which is not cluttered by the post, with evident advantages with respect to conventional sunshades even if equipped with ventilation. Likewise, the vertical portion 1 of the post can be extractable from the footing 7a, as shown by 1b in said Figure 1.

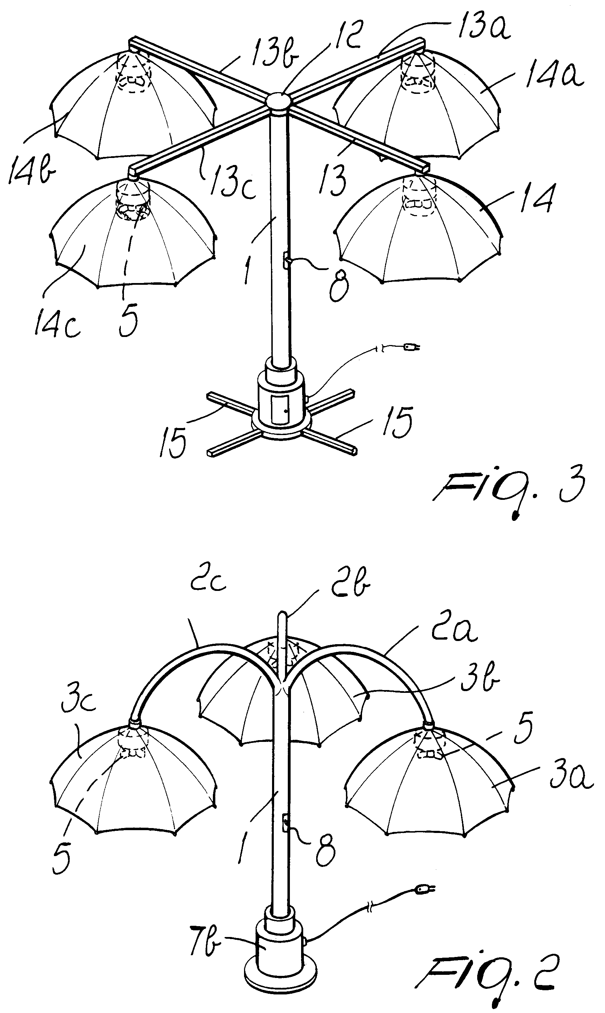

Another embodiment of the support according to the present invention is shown in figure 2; this solution also has a vertical tubular post 1 which, however, is divided into three identical arched arms 2a, 2b, 2c which are mutually angularly spaced; each arm supports the canopy of a sunshade, and inside said canopies, designated by the reference numerals 3a, 3b, 3c, there is a ventilation device 5 which is identical to the one shown in Figure 1. In the case shown in Figure 2, said three arched arms are fixed at 120^{o} to each other, but they can be fitted so that they can be orientated at will, in order to position the sunshades in the best conditions to achieve protection from solar radiation. Also, in this embodiment, both the vertical post 1 and the individual arched arms 2a, 2b, 2c can be telescopically extractable to facilitate transport and storage of the entire structure. The hollow footing 7b can be hollow and can contain a rechargeable battery.

Another embodiment of the present invention is shown in Figure 3; in said figure, a rotatable structure 12 is mounted at the top of the vertical portion 1 of the tubular post and is shaped like a circular plate or the like; four horizontal straight arms, designated by the reference numerals 13, 13a, 13b, 13c, are rigidly anchored to said rotatable structure (or inserted therein with a detachable coupling); four sunshades 14-14a-14b-14c, with a corresponding ventilation device 5, are anchored to the ends of said arms. Said four horizontal arms can also be arranged so that they are fixed at 90^{o} to each other and may also have a constant or telescopically adjustable length. The spoke-like support 15 can also have another configuration, so long as it has a footing which is similar to the one shown in the embodiments of Figures 1 and 2. In this case, furthermore, it is easy to apply to the end of the fixed or rotatable plate 12 a solar panel to supply power to the battery and thus, by means of said battery, supply power to the fans and to any luminaires associated therewith.

The above described Figures 1, 2 and 3 illustrate a multipurpose support which besides being particularly adapted for supporting conventional ventilation devices, is also advantageously adapted for supporting conventional heating heads of the electric-resistor or liquefied-gas type, widely used in private and public spaces to allow gatherings in the open air or even in enclosed spaces in autumn and/or spring, when the low temperature of the air is not always sufficient to allow said gatherings, games or shows.

The support provided with one or more upper arms which are curved in an outward arched shape or are straight and horizontal can in fact be used easily to support, both in the case of a single arched or straight arm and in the case of a plurality of radially-arranged horizontal arms, said heating heads instead of the ventilation devices described above.

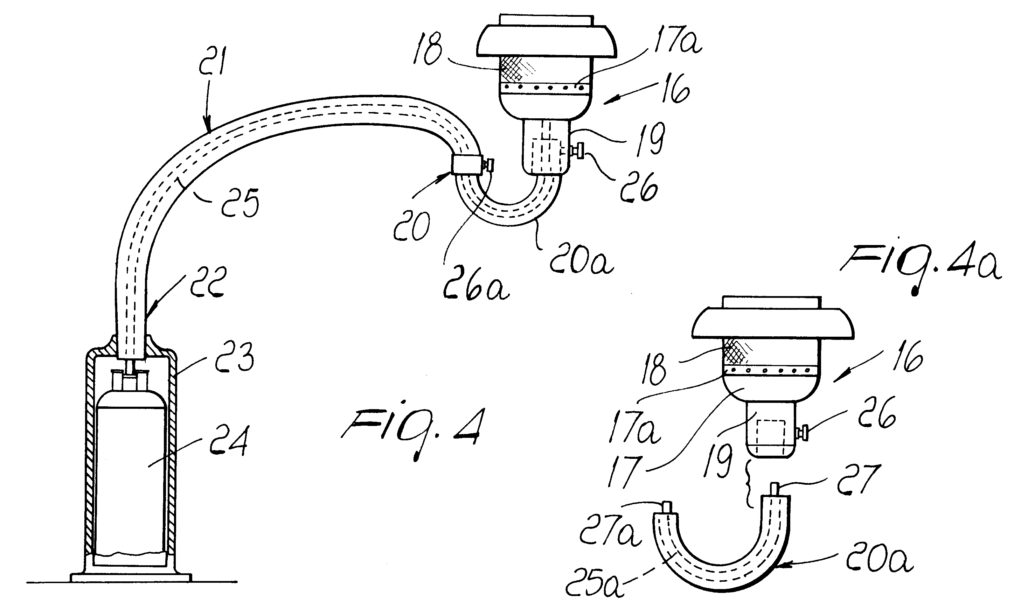

Therefore, also according to the invention, Figures 4a and 4 illustrate respectively a conventional gas-fired heating head and a special support for said head.

More specifically, said conventional heating head, generally designated by the reference numeral 16 in Figures 4 and 4a, is generally constituted by a cage-like head 17 which is substantially cylindrical and encloses a gas-fired burner 17a which is substantially toroidal and is protected by a peripheral metallic mesh 18. Said head fitted with a burner is provided with a tubular sleeve 19 which can be fitted, by means of an arched union 20a, on the end 20 of the arched arm 21 of a post 22 which is rigidly anchored to a hollow supporting body 23 which is similar to the body 7a or 7b of the previous figures; said supporting body is provided with a door which can be opened to allow to accommodate a liquefied-gas bottle 24; a copper pipe 25, located inside the post and the union 20a, is provided in order to connect said burner 17a to the conventional expansion valve of the bottle 24. The coupling of the head 16 to the end 20 of the arm 21 is facilitated by a locking system which is provided by means of screws 26 and 26a; the coupling of the gas pipe 25 to the pipe 25a of the union 20a is automatic by means of the force-fit insertion of the cylindrical pipe portions 27-27a in the ends of the pipe 25 and of the union of the burner inside the head 19.

Accordingly, in order to allow the support to support in a cantilevered manner both a ventilation device and a heating device, it is sufficient to replace the two devices as specified earlier and simultaneously replace the rechargeable battery with the gas bottle.

Said burner can of course be of the linear type; in this case its detachable coupling to the end of the arms is facilitated, since the union 20a can be omitted.

Other embodiments according to the present invention are shown in Figures 5, 6 and 7.

In Figure 5, the support is constituted by a straight post 1, to the top whereof a straight horizontal arm 29 is hinged (or stably fixed) at 28; said arm is rigid or telescopically extendable, and a sunshade 30 of various shapes, with a corresponding fan 5 powered by a rechargeable battery located in the box-like supporting body 7a, is anchored to the free end of said arm 29.

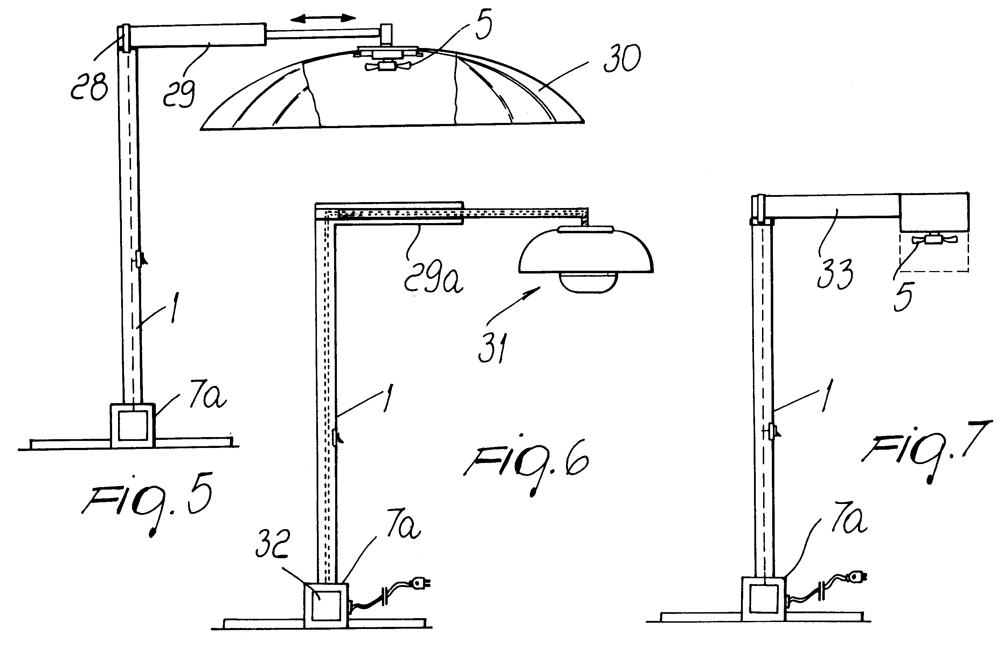

Figure 6 illustrates a support with a horizontal arm 29a which is fixed and telescopically extendable; a head 31 is detachably coupled to the free end of said arm and is provided with a toroidal or linear gas-fired burner supplied by a bottle 32 which is enclosed in the supporting body or footing 7a.

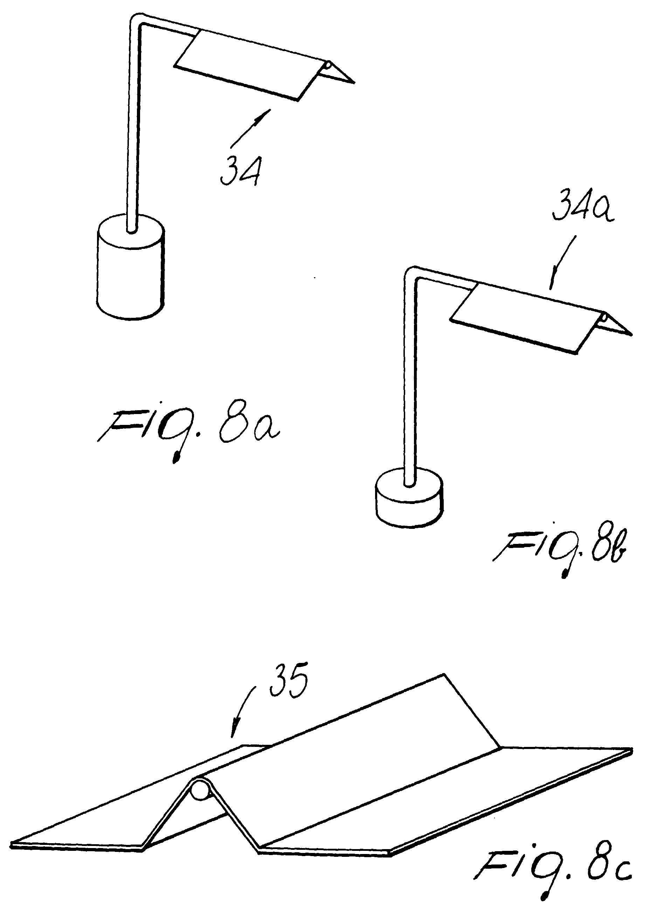

Furthermore, figure 7 illustrates a support with a horizontal arm 33 which supports a fan 5 of the type described earlier.

Besides the previously described embodiments, the present invention also provides for the insertion of a linear radiating burner instead of a circular one as in the previously described embodiments, or of an electric resistor, as shown schematically in Figures 8a-8c in the embodiments designated by 34 and 34a.

Said system has considerable advantages with respect to conventional circular ones, has less bulk, has a larger radiating surface, and allows to associate a wide canopy, as shown by 35 in Figure 8, which can also be of the folding type in order to reduce its bulk when it is inactive.

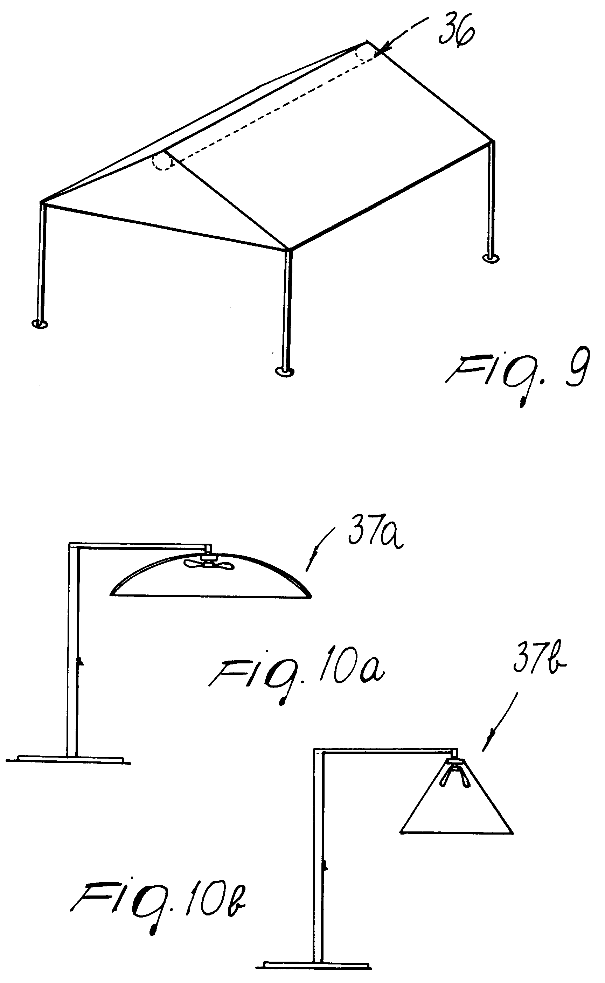

Figure 9 illustrates the possibility of installation in a gazebo-like configuration, besides the sunshade-type installation, shown by 36; this solution allows to also include the fans by interchanging them.

Figures 10a, 10b schematically illustrate, with all the possible combinations described earlier, a suspended fan with movable blades inserted in a sunshade, in which the blades open out when the sunshade is open 37a and are closed when the sunshade is closed 37b.

Furthermore, according to the invention, Figure 11 schematically shows a portable umbrella 38, such as those used to be sheltered from rain, in which a fan with movable or fixed blades for personal refreshment is installed.

Said umbrella can have a dual structure: a rigid one and a movable one, so that it can fold (Figure 11) or with a recess (Figure 11a) to provide rotation space for the blades of the fan.

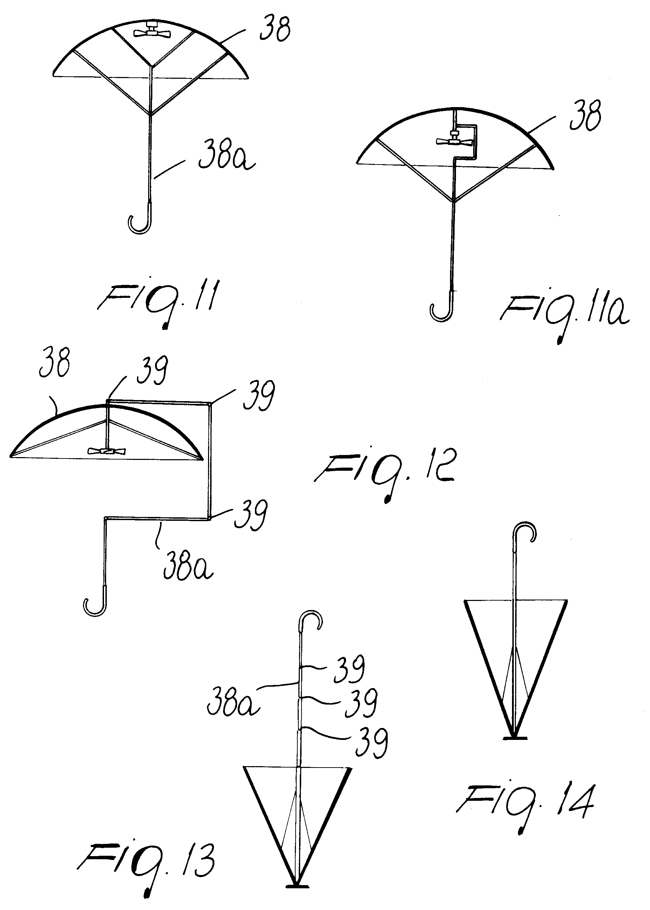

Figure 12 illustrates an umbrella 38 with a fan having fixed or movable blades without a secondary structure, which closes or opens by aligning the joints, as shown by the reference numeral 39; it is also possible to provide it in a foldable type (as in Figure 14) by sliding the joints and the rods 38a, as in conventional travel umbrellas.

In all these cases, the fan is powered by rechargeable batteries (not shown) which are inserted in the rods of the sunshades or in the handle; it is also possible to use a small solar panel.

In addition to the above described embodiments, the support according to the present invention can of course also be provided with structurally and functionally equivalent variations and modifications without abandoning the scope of the protection of said invention.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A support for independently-powered ventilation devices alternatively interchangeable with heating devices of the gas-fired, electric resistor or similar type, used in sunshades, awnings and the like for bathing establishments or on supports of radiating heads for heating outdoor and indoor spaces, characterized in that it comprises by a tubular post (1) which is stably anchored to a footing (7a,7b,23) shaped like an openable box-like body and is contoured, in an upward region, so that it has one or more arms (2,2a,2b,2c,13,13a,13b,13c,21) which are directed substantially horizontally, means being provided, at the free end of said one or more arms, for the detachable coupling of the canopy (3,3a,3b,3c) of a sunshade or the like with the corresponding conventional ventilation device (5) and, alternatively, for the direct coupling of a conventional heating device (16,34,34a) of the gas-fired, electric-resistor or solar-panel type, said substantially horizontal arms (2,2a-2c,13,13a-13c,21) being associated with said tubular post (1) so that they are angularly spaced in a radial arrangement and, if required, being also able to rotate with respect to each other; means (6) being also provided for independently powering said ventilation device (5), said means being constituted by a rechargeable battery (6), which is enclosed in said box-like footing (7a,7b) and is connected to the mains power grid, or by a solar panel; and means for supplying gas to said heating device (16), which are constituted by a bottle (24) which can be alternately accommodated in said footing (23) instead of said battery (6).

2. A support according to claim 1, characterized in that said tubular post (1) is provided so that it is arched in the upper region, so as to form a substantially horizontal arm (2,2a-2c,13,13a-13c) whose length is such that it supports, in a cantilevered manner, the canopy (3,3a-3c) of a sunshade of the fixed or folding type which is shaped like a semicylindrical, quadrangular or polygonal dome or is such as to support the corresponding ventilation devices (5) or heating devices (16).

3. A support according to claim 1, characterized in that said vertical post (1) has, at its top, a plurality of straight, arched and/or variously shaped arms (2,2a-2c,13,13a-13c), all of which are directed substantially horizontally, each arm supporting a sunshade (3,3a-3c) with a ventilation device (5) or a heating device (16), said arms having lengths which allow the sunshades and/or heating devices to cover a large region that is uncluttered by the presence of the tubular post (1).

4. A support according to one or more of the preceding claims, characterized in that both the vertical post (1) and the horizontal, straight or arched arms (2,2a-2c,13,13a-13c) are provided so that they can extend telescopically.

5. A support according to the preceding claims, characterized in that a single fan (5) or a single heating device (16) can be provided at the end of each arm.

6. A support according to the preceding claims, characterized in that it is provided by an umbrella rod (38a), with a fan inserted at the internal top of the canopy, which is of the fixed or folding type, said rod (38a) being of the rigid, articulated or telescopic type, with power supply batteries associated in the rod or with a solar panel applied to the outer top of the umbrella (38).
